# EUROPEAN PATENT SPECIFICATION

(11) **EP 0 549 159 B1**
(45) Date of publication and mention of the grant of the patent: **05.11.1997**
(21) Application number: 92310996.1
(22) Date of filing: 02.12.1992
(51) Int. Cl.: H01R 4/04, H05K 3/32

(54) **Method and adhesive for making electrical and mechanical connections**
Verfahren und Klebstoff zur Herstellung von elektrischen und mechanischen Verbindungen
Procédé et adhésif pour réaliser des connexions électriques et mécaniques

(30) Priority: 06.12.1991 US 804279
(43) Date of publication of application: 30.06.1993
(73) Proprietor: International Business Machines Corporation, Armonk, N.Y. 10504 (US)
(72) Inventor: Mahmoud, Issa S., Apalachin, NY 13732 (US); Partridge, Julian Peter, Austin, TX 78729-3612 (US)
(74) Representative: Burt, Roger James, Dr.

(56) References cited:
- EP-A- 0 110 307
- EP-A- 0 265 077
- DE-A- 1 955 082
- US-A- 3 708 387
- US-A- 4 233 103

## Description

The present invention relates in general to an electrically conductive adhesive for making electrical and mechanical connections between bodies, and in particular to an anisotropic electrically conductive adhesive.

In attaching electronic components to various surfaces, such as those on printed circuit boards or on other electronic components, it is desirable to use a composition or substance that is able to form a mechanical connection between the electronic component and the printed circuit board to hold the component in place. Moreover, the substance should be electrically conductive in order to make an electrical connection between the component and the printed circuit board.

Solder and electrically conductive adhesives are some of the compositions at present utilized to form a mechanical and electrical connection between an electronic component and a printed circuit board. Solder has been used for many years to attach electronic components to printed circuit boards, but solder has a drawback since it contains toxic materials, e.g., lead. Moreover, as the leads (conductors) extending from electronic components and the holes and contacts in which the leads are placed into or onto circuit boards become finer and finer and closer together, it becomes necessary to place precise amounts of the solder very accurately to avoid bridging or short circuiting between the leads of an electronic component or between the leads of two or more electronic components.

The problem of bridging also occurred with electrically conductive adhesives until anisotropic adhesives having the property of being uniaxially conductive were developed. The term "anisotropic" means exhibiting properties with different values when measured along axes in different directions. The term "uniaxially conductive" means for example conductive in a direction along an axis intersecting two parallel planes extending generally perpendicular to the axis.

Electrically conductive adhesive technology currently utilizes point contact between dispersed metallic particles to form a conductive path. In such an arrangement, the mechanical integrity of the connection arises solely from the adhesive properties and the intrinsic strength of a polymeric matrix.

Examples of such anisotropic electrically conductive adhesives and their use are described in US 4568592 and US 4701279. In addition, EP-A-265077 discloses an anisotropic adhesive for bonding electrical components, where during bonding the conductive particles are heated above their melting temperature in order to fuse them together into a conductive path.

Increasing environmental concerns have led to a search for non-toxic alternatives. Many of these alternatives, such as gold or silver, are expensive and still are not very reliable. The anisotropic electrically conductive adhesives that are available contain either gold or silver spheres dispersed in a polymer matrix or polymer spheres coated with silver or nickel. The spheres are forced into contact under an applied load which allows electronic percolation in localized regions. Such an arrangement can experience problems such as electrical failure due to polymer expansion causing the spheres to lose contact with each other. Such arrangements may also have problems with metal oxidation, causing high resistance paths at the interface.

The object of the present invention is to provide an improved electrically conductive adhesive and an improved method of making electrical and mechanical connections between two surfaces.

Accordingly, the present invention provides a method of making an electrical and mechanical connection between two surfaces comprising: coating at least one of said surfaces with an electrically conductive adhesive, said adhesive comprising a polymer component and an electrically conductive component, said polymer component being formed from a material having a thermal expansion coefficient along a selected axis in the range from about 5 to 10 parts per million per degree centigrade, said electrically conductive component comprising particles of an electrically conductive material being loaded within said polymer component material in the range from 10 to 30 percent conductive material by weight based on the total weight of said polymer component material and said conductive material, and said polymer component material having a glass transition temperature lying within the sintering temperature range of said particles of electrically conductive material; positioning said two surfaces in contact and applying pressure to force them together; and heating said adhesive to a temperature in the sintering range of the particle of electrically conducting material and to the glass transition temperature of said polymer component material, but below the melting point of said electrically conducting material; wherein said applied pressure and heating sinter the conductive particles in the adhesive to provide a continuous electrical connection between the two surfaces.

The glass transition temperature of the polymer component material is defined as the temperature at which the polymer material changes from a brittle vitreous state to a plastic state (see Hawley's Condensed chemical Dictionary, Van Nostrand Reinhold, New York).

The invention also relates to a printed circuit board having one or more electrical components connected thereto by an electrically conductive adhesive, said adhesive comprising a polymer component and an electrically conductive component, said polymer component being formed from a material having a thermal expansion coefficient along a selected axis in the range from 5 to 10 parts per million per degree centigrade, said electrically conductive component comprising particles of an electrically conductive material being loaded within said polymer component material in the range from about 10 to 30 percent conductive material by weight based on the total weight of said polymer component material and said conductive material, said polymer component material having a glass transition temperature lying within the sintering temperature range of said particles of electrically conductive material, wherein said particles are sintered together so as to provide a continuous electrical connection between the printed circuit board and said one or more electrical components.

In order that the invention may be more readily understood a more detailed embodiment of the invention will now be described with reference to the accompanying drawing, in which:
Figure 1 depicts a schematic structure of a prior art conductive adhesive with 60 percent by volume metal filler; and
Figure 2 is a schematic structure of the conductive adhesive of the embodiment of the invention to be described.

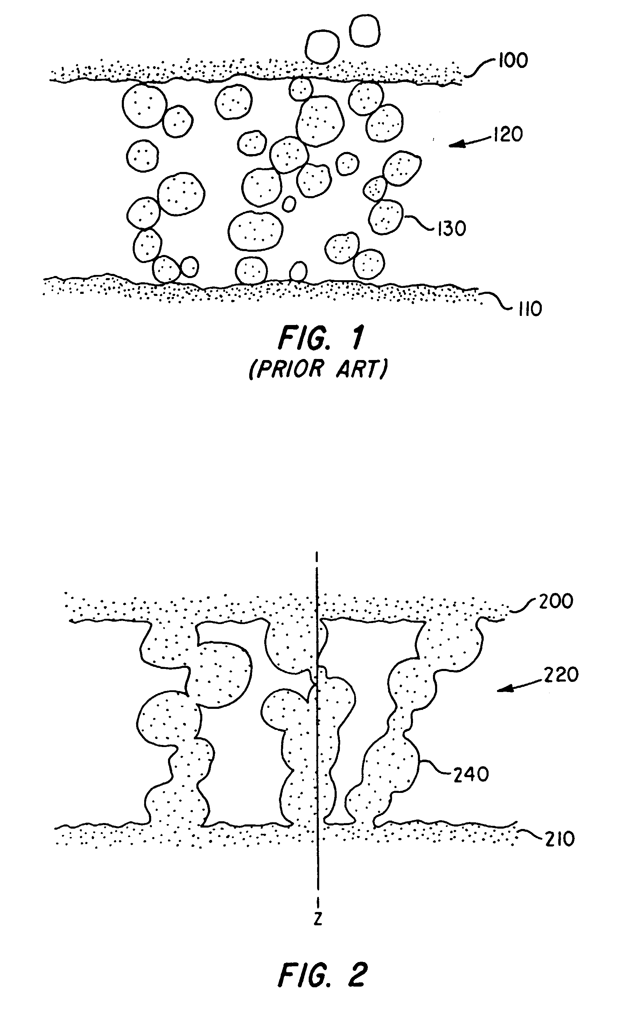

As can be seen with reference to Figure 1, there is depicted a schematic structure of a prior art electrically conductive adhesive with 60 percent by volume of metal filler for forming a connection between an electronic component surface 100 and a printed circuit board surface 110. The conductive adhesive comprises a polymer 120 containing tiny spheres or particles of conductive materials 130 such as gold, silver, or lead-tin solder and is utilized to form a mechanical and electrical connection between electronic component surface 100 and printed circuit board surface 110. The electrical connection is formed by the contact or close proximity of the particles of conductive materials 130 in the conductive adhesive. One drawback with this type of conductive adhesive is that polymer expansion of polymer 120 can lead to increased resistance in the connection and eventually, electrical failure of the connection.

Figure 2 is a schematic structure of a conductive adhesive according to one embodiment of the present invention. An electronic component surface 200 and a printed circuit board surface 210 are connected mechanically and electrically with an anisotropic polymer 220 and continuous segments of conductive material 240.

The anisotropic conductive adhesive illustrated provides electrical conduction through a fused or metallurgically bonded interface between the electronic component surface 200 and the printed circuit board surface 210, in which electrical connection is desired, instead of the point contact system illustrated in Fig 1.

The adhesive illustrated in Fig. 2 contains two major components, an organic (polymer and solvent) component and a metallic electrically conductive component. These two components form an electrically conductive polymer matrix with the conductive component sintering to form continuous segments of conductive material 240. The polymer component of the adhesive must be thermoplastic if reworking of electronic components attached to the printed circuit boards is desired.

The polymer component utilized produces an anisotropic adhesive that is uniaxially electrically conductive in a direction along an axis intersecting the two surfaces in which electrical contact is desired, the z-axis. This arrangement is in contrast to an isotropic adhesive that has equal electrical conductivity properties in all directions. In addition, the polymer component has a glass transition temperature that is within the range of the sintering temperature of the metallic electrically conductive component of the adhesive. In other words, the glass transition temperature is below the melting point of the conductive particles used in the conductive component of the adhesive being described.

The conductive component of the adhesive comprises particles of electrically conductive materials. These conductive particles may be of a metal or an alloy. The conductive particles have a sintering temperature range that overlaps or encompasses the glass transition temperature of the polymer component of the adhesive. Sintering between particles of a metal or alloy occurs when the metal or alloy particles are heated to temperatures sufficient to bond them together metallurgically. In effect, the particles have fused, but have not melted. Sintering the metal or alloy particles in the adhesive results in a continuous connection between the surfaces, such as an electronic component's leads and contacts on a printed circuit board, rather than just resulting in the particles touching or being in near proximity to each other.

This continuous connection, formed by sintering the conductive particles to form an electrical connection between two surfaces, has an advantage over the conductive adhesives illustrated in Fig. 1. Such an electrical connection is not as susceptible to failure due to polymer expansion causing conductive particles to lose contact as in the conductive adhesives illustrated in Fig. 1. Moreover, oxidation of the fused conductive particles is also less likely to cause increased resistivity problems in the arrangement being described.

Additionally, sintering of the conductive particles, i.e., metal or alloy, has the added benefit of enhancing the mechanical strength of the connection by adding to the mechanical integrity provided by the polymer component. This additional strength of the connection is an added benefit over the arrangement in the contact system conductive adhesives illustrated in Fig. 1.

While sintering the conductive particles, it is important to avoid melting the metal or alloy particles. If the particles melt, rather than forming a continuous connection, the metal or alloy particles may cluster or clump in a portion of the polymer component, resulting in no electrical connection or a poor electrical connection being formed.

The adhesive may contain a polymer component that is thermoplastic. Such a polymer component is necessary in order to rework items or components attached with the adhesive. The polymer component of the adhesive should have a thermal expansion coefficient along the z-axis in the range of about 5 parts per million to about 10 parts per million per degree centigrade.

The sintering temperature of the conductive particles and the glass transition temperature of the polymer system may be almost any temperature with the requirement that the glass transition temperature be within the sintering temperature range. Restraints as to the sintering temperature range and glass transition temperature are also set by the electronic components being joined together or attached to surfaces. The temperatures cannot be above the temperature at which any such electronic component would be destroyed, damaged, or rendered useless.

Consequently, the temperatures that any such electrical component can stand form the upper limit of the sintering temperature ranges and glass transition temperatures of the adhesive being described. In other words, the sintering temperature range of the conductive component may be high as long as some portion of the range is low enough to allow sintering of the conductive particles without destroying the electronic components being attached. The glass transition temperature of the polymer component must also be low enough to not cause damage to any such electronic component.

When using a thermoplastic polymer, the lower limit of the temperature range for the glass transition temperature must be above the temperature at which the printed circuit boards and electronic components are tested after assembly or the temperature during actual use. Too low a glass transition temperature may result in the adhesive flowing, causing a possible loss of mechanical and electrical connection. The sintering temperature can also be low as long as the melting point of the conductive particles is above these temperatures.

Another parameter of the conductive adhesive being described is the loading of the metal or alloy particles of the metal or alloy system. The loading affects the uniaxial conductive properties in the anisotropic adhesive. All references to the term "loading" of the conductive materials in the arrangement being described means loading of the conductive particles in the polymer by weight based on the total weight of the polymer and the conductive material. The loading range of the metal or alloy particles should be in the range of about 10 percent to 30 percent of conductive particles by weight based on the total weight of the polymer and the conductive material. The optimal loading range is from about 15 percent to 20 percent. These ranges of loading may vary about two to three percent depending on the size and shape of the particles of conductive material utilized.

In contrast to the loading in the arrangement being described, loading in known conductive adhesives ranges from 60 percent to 80 percent of metal particles. The lower loading in the arrangement being described is a factor in making the conductive adhesive uniaxially conductive. If the loading is too high, the adhesive will not become uniaxially conductive and, in fact, may become conductive in all directions, resulting in the problem of bridging. On the other hand, if the loading of the conductive particles in the polymer is too low, little or no electrical connection will be made, even after sintering the conductive particles.

The polymer component of the adhesive may be a thermoplastic polymer to allow reworking with a glass transition temperature in the range of about 150°C to 250°C. In such an arrangement the conductive component of the adhesive must have a sintering temperature range somewhere within the range of about 100°C to about 250°C. In addition, the loading must be from about 15 percent to 20 percent of metal or alloy particles by weight. This range of temperatures is well within the temperature range that many electronic components can stand without being damaged or rendered useless.

The adhesive includes a metal alloy as the conductive component of the adhesive. This metal alloy preferably has a melting point below 225°C which allows sintering of the particles during the polymer reflow or curing of the conductive adhesive. One suitable alloy, among others, is a tin-gold eutectic that is 10 percent gold. This alloy can be mixed with a thermoplastic copolymer such as the polymer having the segments PMDA-ODA-6FDA to form the conductive adhesive system being described.

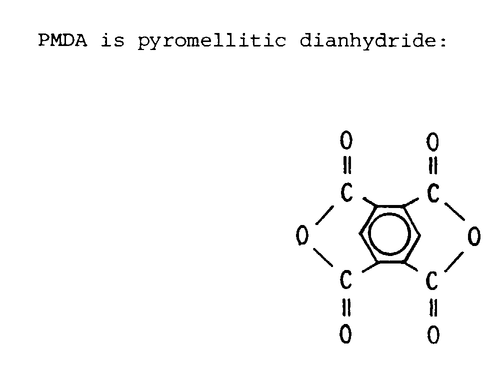

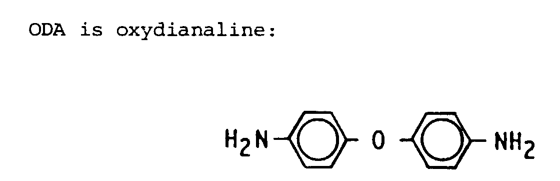

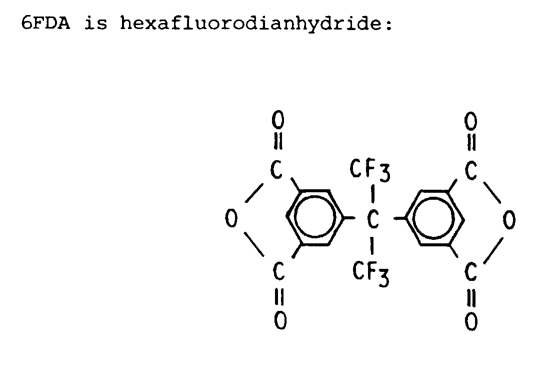

This thermoplastic copolymer can be synthesized by reacting one mole of ODA with one mole PMDA in an acetamid solvent at room temperature for at least one hour. The solution is then heated to 90°C and one mole of 6FDA is added to the solution. This solution is reacted for 3 to 5 hours. The final solution should contain between 30 to 35 percent solids.

The adhesive paste is produced by adding the metal alloy, 90 percent tin and 10 percent gold in this embodiment, to the solution prepared in polymer synthesis. The total amount of polymer to alloy ratio is between 80 to 85 percent polymer to 15 to 20 percent metal by weight. Next, the mixture of metal alloy and polymer is stirred very slowly for 2 to 3 hours until a very homogeneous mixture is obtained. The metal filler in this particular embodiment is in spherical shapes, of 15 to 20 micrometers in diameter. In such a conductive adhesive, the alloy begins to sinter around 100°C to 217°C with the polymer component reflowing between 200°C and 300°C.

The conductive adhesive described has an advantage of being low cost as compared to adhesives using gold or silver. Examples of other alloys that could be used include a bismuth gold alloy that is 18 percent gold and a tin silver alloy that is 4 percent silver. The mixtures of these particular examples could be varied by ± 2 percent. Other alloys beyond these examples will be apparent to those skilled in the art. The conductive adhesive described is non-toxic when compared to the adhesive using lead based solders, making it environmentally desirable.

Another advantage of the conductive adhesive described is that the electrical connection does not suffer from the same problems of polymer expansion as with currently available conductive adhesives. In addition, the fused connection helps to enhance the mechanical integrity of the connection.

The conductive adhesive described may be used to form a connection between an electrical component and a printed circuit board by placing the adhesive on the areas on the board or/and component between which an electrical and mechanical connection is desired. Then, the electrical component is placed onto the board. Next, pressure is utilized to compress the adhesive between the contact surfaces of the electronic component and the printed circuit board. This pressure is applied while the adhesive is set by heating the adhesive to the temperature for glass transition of the polymer and sintering of the electrically conductive particles.

The pressure applied during heating is applied along the z-axis intersecting the two surfaces being connected. This pressure also causes the conductive particles to make contact, while the heating causes the conductive particles to sinter and form a continuous electrical connection. As a result, the adhesive becomes uniaxially electrically conductive along the z-axis.

## Claims

1. A method of making an electrical and mechanical connection between two surfaces (200, 210) comprising:
coating at least one of said surfaces with an electrically conductive adhesive, said adhesive comprising a polymer component and an electrically conductive component, said polymer component being formed from a material having a thermal expansion coefficient along a selected axis in the range from about 5 to 10 parts per million per degree centigrade, said electrically conductive component comprising particles of an electrically conductive material being loaded within said polymer component material in the range from 10 to 30 percent conductive material by weight based on the total weight of said polymer component material and said conductive material, and said polymer component material having a glass transition temperature lying within the sintering temperature range of said particles of electrically conductive material;
positioning said two surfaces in contact and applying pressure to force them together; and
heating said adhesive to a temperature in the sintering range of the particle of electrically conducting material and to the glass transition temperature of said polymer component material, but below the melting point of said electrically conducting material;
wherein said applied pressure and heating sinter the conductive particles in the adhesive to provide a continuous electrical connection (240) between the two surfaces.

2. The method of claim 1 wherein the glass transition temperature of the adhesive is above 150°C.

3. The method of claim 2 wherein the glass transition temperature of the adhesive is between 150°C and 300°C.

4. The method of claim 1, 2 or 3, wherein said sintering temperature range of the adhesive is between 100°C and 250°C.

5. The method of any preceding claim, wherein said polymer component is a thermoplastic polymer.

6. The method of claim 5, wherein said polymer component material is formed from a dianhydride, an oxydianaline and a hexafluorodianhydride.

7. The method of any preceding claim, wherein said conductive particles are a metal alloy.

8. The method of claim 7, wherein said conductive particles are tin-gold alloy, having about 90 percent tin and 10 percent gold.

9. The method of any preceding claim, wherein the particles of an electrically conductive material are loaded within said polymer component material in the range from 15 to 20 percent conductive material by weight based on the total weight of said polymer component material and said conductive material.

10. A printed circuit board having one or more electrical components connected thereto by an electrically conductive adhesive, said adhesive comprising a polymer component and an electrically conductive component, said polymer component being formed from a material having a thermal expansion coefficient along a selected axis in the range from about 5 to 10 parts per million per degree centigrade, said electrically conductive component comprising particles of an electrically conductive material being loaded within said polymer component material in the range from 10 to 30 percent conductive material by weight based on the total weight of said polymer component material and said conductive material, said polymer component material having a glass transition temperature lying within the sintering temperature range of said particles of electrically conductive material, wherein said particles are sintered together so as to provide a continuous electrical connection between the printed circuit board and said one or more electrical components.

11. The printed circuit board of claim 10 wherein the glass transition temperature of the adhesive is above 150°C.

12. The printed circuit board of claim 11 wherein the glass transition temperature of the adhesive is between 150°C and 300°C.

13. The printed circuit board of claim 10, 11 or 12, wherein said sintering temperature range of the adhesive is between 100°C and 200°C.

14. The printed circuit board of any of claims 10 to 13, wherein said polymer component is a thermoplastic polymer.

15. The printed circuit board of claim 14, wherein said polymer component material is formed from a dianhydride, an oxydianaline and a hexafluorodianhydride.

16. The printed circuit board of any of claims 10 to 15, wherein said conductive particles are a metal alloy.

17. The printed circuit board of claim 16, wherein said conductive particles are tin-gold alloy, having about 90 percent tin and 10 percent gold.

18. The printed circuit board of any of claims 10 to 17, wherein the particles of an electrically conductive material are loaded within said polymer component material in the range from 15 to 20 percent conductive material by weight based on the total weight of said polymer component material and said conductive material.

## Patentansprüche

1. Verfahren zur Herstellung einer elektrischen und mechanischen Verbindung zwischen zwei Oberflächen (200, 210), das umfaßt:
Beschichten wenigstens einer der Oberflächen mit einem elektrisch leitfähigen Klebemittel, wobei das Klebemittel eine Polymerkomponente und eine elektrisch leitfähige Komponente beinhaltet, die Polymerkomponente aus einem Material mit einem thermischen Ausdehnungskoeffizienten entlang einer ausgewählten Achse im Bereich von etwa 5 bis 10 Teile pro Million pro Grad Celsius gebildet ist, die elektrisch leitfähige Komponente Partikel aus einem elektrisch leitfähigen Material beinhaltet, die innerhalb des Materials der Polymerkomponente im Bereich von 10 Gewichtsprozent bis 30 Gewichtsprozent leitfähiges Material bezogen auf das Gesamtgewicht des Materials der Polymerkomponente und des leitfähigen Materials eingelagert sind, und das Material der Polymerkomponente eine Glasübergangstemperatur besitzt, die innerhalb des Sintertemperaturbereichs der Partikel aus elektrisch leitfähigem Material liegt;
Positionieren der zwei Oberflächen in Kontakt miteinander und Anwenden eines Druckes, um sie zusammenzupressen; und
Erwärmen des Klebemittels auf eine Temperatur im Sinterbereich der Partikel aus elektrisch leitfähigem Material und auf die Glasübergangstemperatur des Materials der Polymerkomponente, jedoch unterhalb des Schmelzpunktes des elektrisch leitenden Materials;
wobei der angewendete Druck und das Erwärmen die leitfähigen Partikel in dem Klebemittel sintern, um eine kontinuierliche elektrische Verbindung (240) zwischen den zwei Oberflächen bereitzustellen.

2. Verfahren nach Anspruch 1, wobei die Glasübergangstemperatur des Klebemittels über 150 °C liegt.

3. Verfahren nach Anspruch 2, wobei die Glasübergangstemperatur des Klebemittels zwischen 150 °C und 300 °C liegt.

4. Verfahren nach Anspruch 1, 2 oder 3, wobei der Sintertemperaturbereich des Klebemittels zwischen 100 °C und 250 °C liegt.

5. Verfahren nach irgendeinem vorhergehenden Anspruch, wobei die Polymerkomponente ein thermoplastisches Polymer ist.

6. Verfahren nach Anspruch 5, wobei das Material der Polymerkomponente aus einem Dianhydrid, einem Oxydianilin und einem Hexafluordianhydrid gebildet ist.

7. Verfahren nach irgendeinem vorhergehenden Anspruch, wobei die leitfähigen Partikel aus einer Metallegierung bestehen.

8. Verfahren nach Anspruch 7, wobei die leitfähigen Partikel aus einer Zinn-Gold-Legierung mit etwa 90 Prozent Zinn und 10 Prozent Gold bestehen.

9. Verfahren nach irgendeinem vorhergehenden Anspruch, wobei die Partikel aus einem elektrisch leitfähigen Material innerhalb des Materials der Polymerkomponente im Bereich von 15 Gewichtsprozent bis 20 Gewichtsprozent leitfähiges Material bezogen auf das Gesamtgewicht des Materials der Polymerkomponente und des leitfähigen Materials eingelagert sind.

10. Leiterplatte mit einer oder mehreren elektrischen Komponenten, die durch ein elektrisch leitfähiges Klebemittel mit derselben verbunden sind, wobei das Klebemittel eine Polymerkomponente und eine elektrisch leitfähige Komponente beinhaltet, die Polymerkomponente aus einem Material mit einem thermischen Ausdehnungskoeffizienten entlang einer ausgewählten Achse im Bereich von etwa 5 bis 10 Teile pro Million pro Grad Celsius gebildet ist, die elektrisch leitfähige Komponente Partikel aus einem elektrisch leitfähigen Material beinhaltet, die innerhalb des Materials der Polymerkomponente im Bereich von 10 Gewichtsprozent bis 30 Gewichtsprozent leitfähiges Material bezogen auf das Gesamtgewicht des Materials der Polymerkomponente und des leitfähigen Materials eingelagert sind, das Material der Polymerkomponente eine Glasübergangstemperatur besitzt, die innerhalb des Sintertemperaturbereichs der Partikel aus elektrisch leitfähigem Material liegt, und wobei die Partikel zusammengesintert werden, um so eine kontinuierliche elektrische Verbindung zwischen der Leiterplatte und der einen oder den mehreren elektrischen Komponenten bereitzustellen.

11. Leiterplatte nach Anspruch 10, wobei die Glasübergangstemperatur des Klebemittels über 150 °C liegt.

12. Leiterplatte nach Anspruch 11, wobei die Glasübergangstemperatur des Klebemittels zwischen 150 °C und 300 °C liegt.

13. Leiterplatte nach Anspruch 10, 11 oder 12, wobei der Sintertemperaturbereich des Klebemittels zwischen 100 °C und 200 °C liegt.

14. Leiterplatte nach irgendeinem der Ansprüche 10 bis 13, wobei die Polymerkomponente ein thermoplastisches Polymer ist.

15. Leiterplatte nach Anspruch 14, wobei das Material der Polymerkomponente aus einem Dianhydrid, einem Oxydianilin und einem Hexafluordianhydrid gebildet ist.

16. Leiterplatte nach irgendeinem der Ansprüche 10 bis 15, wobei die leitfähigen Partikel aus einer Metallegierung bestehen.

17. Leiterplatte nach Anspruch 16, wobei die leitfähigen Partikel aus einer Zinn-Gold-Legierung mit etwa 90 Prozent Zinn und 10 Prozent Gold bestehen.

18. Leiterplatte nach irgendeinem der Ansprüche 10 bis 17, wobei die Partikel aus einem elektrisch leitfähigen Material innerhalb des Materials der Polymerkomponente im Bereich von 15 Gewichtsprozent bis 20 Gewichtsprozent leitfähiges Material bezogen auf das Gesamtgewicht des Materials der Polymerkomponente und des leitfähigen Materials eingelagert sind.

## Revendications

1. Procédé de réalisation d'une connexion électrique et mécanique entre deux surfaces (200, 210), comprenant :
le revêtement d'au moins l'une desdites surfaces avec un adhésif électriquement conducteur, ledit adhésif comprenant un composant de polymère et un composant électriquement conducteur, ledit composant de polymère étant formé d'un matériau présentant un coefficient de dilatation thermique, suivant un axe sélectionné, dans la plage de 5 à 10 parties par million par degré centigrade, ledit composant électriquement conducteur comprenant des particules d'un matériau électriquement conducteur qui sont chargées à l'intérieur dudit matériau de composant de polymère suivant la plage de 10 à 30 pour cent en poids de matériau conducteur sur la base du poids total dudit matériau de composant de polymère et dudit matériau conducteur, et ledit matériau de composant de polymère présentant une température de transition vitreuse située à l'intérieur de la plage de température de frittage desdites particules de matériau électriquement conducteur,
le positionnement desdites deux surfaces en contact et l'application d'une pression pour les maintenir ensemble, et
le chauffage dudit adhésif jusqu'à une température comprise dans la plage de frittage des particules de matériau électriquement conducteur et jusqu'à la température de transition vitreuse dudit matériau de composant de polymère, mais au-dessous du point de fusion dudit matériau électriquement conducteur,
dans lequel ladite pression appliquée et ledit chauffage frittent les particules conductrices dans l'adhésif pour procurer une connexion électrique continue (240) entre les deux surfaces.

2. Procédé selon la revendication 1, dans lequel la température de transition vitreuse de l'adhésif est au-dessus de 150° C.

3. Procédé selon la revendication 2, dans lequel la température de transition vitreuse de l'adhésif est comprise entre 150° C et 300° C.

4. Procédé selon la revendication 1, 2, ou 3, dans lequel ladite plage de température de frittage de l'adhésif est comprise entre 100° C et 250° C.

5. Procédé selon l'une quelconque des revendications précédentes, dans lequel ledit composant de polymère est un polymère thermoplastique.

6. Procédé selon la revendication 5, dans lequel ledit matériau de composant de polymère est formé d'un dianhydride, d'une oxydianaline et d'un hexafluorodianhydride.

7. Procédé selon l'une quelconque des revendications précédentes, dans lequel lesdites particules conductrices sont en alliage métallique.

8. Procédé selon la revendication 7, dans lequel lesdites particules conductrices sont en alliage d'étain-or, comportant environ 90 pour cent d'étain et 10 pour cent d'or.

9. Procédé selon l'une quelconque des revendications précédentes, dans lequel les particules d'un matériau électriquement conducteur sont chargées à l'intérieur dudit matériau de composant de polymère dans la plage de 15 pour cent à 20 pour cent en poids de matériau conducteur sur la base du poids total dudit matériau de composant de polymère et dudit matériau conducteur.

10. Carte de circuit imprimé comportant un ou plusieurs composants électriques reliés à celle-ci par un adhésif électriquement conducteur, ledit adhésif comprenant un composant de polymère et un composant électriquement conducteur, ledit composant de polymère étant formé d'un matériau présentant un coefficient de dilatation thermique, suivant un axe sélectionné, dans la plage d'environ 5 à 10 parties par million par degré centigrade, ledit composant électriquement conducteur comprenant des particules d'un matériau électriquement conducteur qui sont chargées à l'intérieur dudit matériau de composant de polymère dans la plage de 10 pour cent à 30 pour cent en poids de matériau conducteur sur la base du poids total dudit matériau de composant de polymère et dudit matériau conducteur, ledit matériau de composant de polymère présentant une température de transition vitreuse située à l'intérieur de la plage de température de frittage desdites particules de matériau électriquement conducteur, dans lequel lesdites particules sont frittées ensemble de façon à procurer une connexion électrique continue entre la carte de circuit imprimé et lesdits un ou plusieurs composants électriques.

11. Carte de circuit imprimé selon la revendication 10, dans laquelle la température de transition vitreuse de l'adhésif est au-dessus de 150°C.

12. Carte de circuit imprimé selon la revendication 11, dans laquelle la température de transition vitreuse de l'adhésif est comprise entre 150° C et 300° C.

13. Carte de circuit imprimé selon la revendication 10, 11 ou 12, dans laquelle ladite plage de température de frittage de l'adhésif est comprise entre 100° C et 200° C.

14. Carte de circuit imprimé selon l'une quelconque des revendications 10 à 13, dans laquelle ledit composant de polymère est un polymère thermoplastique.

15. Carte de circuit imprimé selon la revendication 14, dans laquelle ledit matériau de composant de polymère est formé d'un dianhydride, d'une oxydianaline et d'un hexafluorodianhydride.

16. Carte de circuit imprimé selon l'une quelconque des revendications 10 à 15, dans laquelle lesdites particules conductrices sont en alliage métallique.

17. Carte de circuit imprimé selon la revendication 16, dans laquelle lesdites particules conductrices sont en alliage étain-or, comportant environ 90 pour cent d'étain et 10 pour cent d'or.

18. Carte de circuit imprimé selon l'une quelconque des revendications 10 à 17, dans laquelle les particules d'un matériau électriquement conducteur sont chargées à l'intérieur dudit matériau de composant de polymère dans la plage de 15 à 20 pour cent en poids de matériau conducteur sur la base du poids total dudit matériau de composant de polymère et dudit matériau conducteur.
